# FASCICULE DE BREVET EUROPEEN

(11) **EP 3 877 774 B1**
(45) Date de publication et mention de la délivrance du brevet: **20.03.2024**
(21) Numéro de dépôt: 19806309.1
(22) Date de dépôt: 16.10.2019
(51) Int. Cl.: G01R 31/385, G01R 31/382, G01R 31/50, G01R 31/67

(54) **DISPOSITIF D'INHIBITION DE LA SORTIE DE COURANT D'UN ÉQUIPEMENT, À ÉLÉMENTS DE COMMUTATION À FUITE SURVEILLÉE**
VORRICHTUNG ZUR UNTERDRÜCKUNG DER STROMABGABE AUS EINER VORRICHTUNG MIT SCHALTELEMENTEN FÜR ÜBERWACHTE LECKAGE
DEVICE FOR SUPPRESSING THE OUTPUT OF CURRENT FROM AN APPARATUS, WITH MONITORED-LEAKAGE SWITCHING ELEMENTS

(30) Priorité: 08.11.2018 FR 1871418
(43) Date de publication de la demande: 15.09.2021
(73) Titulaire: Stellantis Auto SAS, 78300 Poissy (FR)
(72) Inventeur: BERT, Jean-claude, 69420 CONDRIEU (FR); PERSEVAL, Herve, 91310 MONTLHERY (FR)
(86) Numéro de dépôt international: PCT/FR2019/052442
(87) Numéro de publication internationale: WO 2020/094934

(56) Documents cités:
- US-A- 4 449 080
- US-A1- 2002 075 004
- US-A1- 2009 066 161
- US-A1- 2013 342 214

## Description

### Domaine technique de l'invention

L'invention concerne les dispositifs d'inhibition qui équipent la sortie de certains équipements (électriques ou électroniques) délivrant un courant électrique.

### Etat de la technique

Certains équipements (électriques ou électroniques) comprennent une sortie sur laquelle ils délivrent un courant électrique destiné à alimenter au moins un autre équipement (électrique ou électronique) ou un réseau d'alimentation de plusieurs équipements (électriques ou électroniques). C'est, par exemple et non limitativement, le cas de certaines batteries destinées à équiper certains systèmes, comme par exemple certains véhicules (éventuellement de type automobile).

Afin d'isoler l'équipement lorsqu'il fait l'objet d'un dysfonctionnement potentiellement dangereux ou lorsque l'un au moins des autres équipements qu'il doit alimenter fait l'objet d'un dysfonctionnement, sa sortie est équipée en série d'un dispositif d'inhibition à états ouvert (et passant) et fermé (et non passant).

Généralement, ce dispositif d'inhibition comprend des relais redondants qui ne peuvent présenter qu'un état ouvert et un état fermé, comme décrit, notamment, dans le document brevet FR 2948461. Ce type de dispositif d'inhibition présente un pouvoir de coupure de courant relativement limité, assure un nombre de commutations (et donc d'inhibitions) relativement faible, nécessite une énergie importante pour commander ses relais, et pose des problèmes de fiabilité.

*On connait par le document* US 2013/342214 *un système de gestion de batterie comprenant une première unité de commutation couplée à une anode d'une première cellule de batterie d'un bloc-batterie, ayant un premier transistor de type couplé à l'anode de la première cellule de batterie.*

*On connait aussi par le document* US 4 449 080 *un circuit de détection et d'inhibition de défaut pour une unité de commande de puissance dans un véhicule à moteur de traction électrique.*

*On connait aussi par le document* US 2009/066161 *un système de gestion de l'alimentation comprenant une unité de gestion de l'alimentation utilisable pour contrôler une première source d'alimentation et une seconde source d'alimentation. La seconde source d'alimentation peut être chargée par la première source d'alimentation via un chemin de charge.*

*On connait aussi par le document* US 2002/075004 *un dispositif pour la mesure de la tension d'une batterie comprenant un ensemble de premières branches de commutation, un système de changement de niveau pour modifier la valeur de la tension de chaque batterie; un convertisseur analogique*/*numérique, une section de contrôle de tension de référence.*

L'invention a donc notamment pour but d'améliorer la situation.

### Présentation de l'invention

Elle propose notamment à cet effet un dispositif d'inhibition, destiné à inhiber la sortie d'un équipement délivrant un courant électrique, selon la revendication 1.

Caractéristiques additionnelles sont définies par les revendications dépendantes 2-4.

L'invention propose également un équipement, selon la revendication 5, comprenant une sortie délivrant un courant électrique, et un dispositif d'inhibition du type de celui présenté ci-avant et installé sur sa sortie.

Par exemple, cet équipement, selon la revendication 6, constitue une batterie.

L'invention, selon les revendications 7 et 8, propose également un véhicule, éventuellement de type automobile, et comprenant au moins un équipement du type de celui présenté ci-avant.

### Brève description des figures

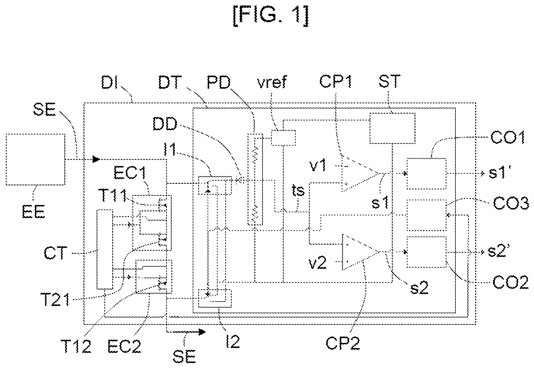

D'autres caractéristiques et avantages de l'invention apparaîtront à l'examen de la description détaillée ci-après, et du dessin annexé, sur lequel la figure 1 illustre schématiquement et fonctionnellement un équipement électrique comprenant une sortie équipée d'un exemple de réalisation d'un dispositif d'inhibition selon l'invention.

### Description détaillée de l'invention

L'invention a notamment pour but de proposer un dispositif d'inhibition DI destiné à équiper la sortie de courant SE d'un équipement électrique ou électronique EE

Dans ce qui suit, on considère, à titre d'exemple non limitatif, que le dispositif d'inhibition DI est destiné à équiper la sortie SE d'un équipement électrique ou électronique EE qui constitue une batterie. Mais l'invention n'est pas limitée à cette application. En effet, un dispositif d'inhibition DI, selon l'invention, peut équiper la sortie de n'importe quel équipement électrique ou électronique devant délivrer un courant électrique.

Par ailleurs, on considère dans ce qui suit, à titre d'exemple non limitatif, que la batterie EE est destinée à équiper un véhicule, par exemple de type automobile. Mais l'invention n'est pas limitée à cette application. En effet, la batterie EE (et plus généralement l'équipement) peut faire partie de tout système, appareil (y compris électroménager), installation (éventuellement industrielle), ou bâtiment. Ainsi, la batterie EE (et plus généralement l'équipement) peut faire partie de tout type de véhicule (terrestre, maritime (ou fluvial), ou aérien).

On notera que la batterie EE peut être, ici, une batterie de servitude (de type basse tension (typiquement comprise entre 12 V et 48 V)), ou bien destinée à fournir de l'énergie électrique pour au moins une machine électrique motrice d'un groupe motopropulseur du véhicule (et donc de type haute tension ou très haute tension).

On a schématiquement représenté sur la figure 1 un équipement électrique EE (ici une batterie de véhicule) comprenant une sortie SE destinée à délivrer un courant électrique et équipée d'un exemple de réalisation d'un dispositif d'inhibition DI selon l'invention. Ce dispositif d'inhibition DI est destiné à inhiber la sortie SE pour qu'elle ne délivre pas son courant (électrique), en cas de besoin (c'est-à-dire lorsque son équipement EE fait l'objet d'un dysfonctionnement potentiellement dangereux ou lorsque au moins un autre équipement que ce dernier (EE) doit alimenter en courant fait l'objet d'un dysfonctionnement.

Comme illustré sur la figure 1, un dispositif d'inhibition DI, selon l'invention, comprend au moins des premier EC1 et second EC2 éléments de commutation, une diode DD, un pont diviseur PD, une source de tension ST, un premier comparateur CP1 et un contrôleur CT.

Les premier EC1 et second EC2 éléments de commutation sont destinés à être installés en série, tête-bêche (ou de façon opposée), sur la sortie SE de la batterie EE, et peuvent chacun être placés soit dans un état ouvert passant (et donc autorisant le passage de courant), soit dans un état fermé non passant (et donc interdisant le passage de courant en l'absence de fuite).

Par exemple, et comme illustré non limitativement sur la figure 1, chacun des premier EC1 et second EC2 éléments de commutation peut comprendre au moins un premier transistor à effet de champ (ou FET (« Field Effect Transistor »)) T1j (j = 1 ou 2). Dans ce cas, chaque premier transistor à effet de champ T1j peut, par exemple, être de type MOSFET (« Metal Oxyde Semiconductor Field Effect Transistor » - FET à grille métallique électriquement isolée du substrat par un diélectrique de type SiO₂).

L'homme de l'art comprendra que les premier EC1 et second EC2 éléments de commutation sont dimensionnés en fonction du courant qui est délivré par la batterie EE sur sa sortie SE.

La source de tension ST est isolée totalement de la batterie EE. Elle est destinée à fournir une tension vref constante.

Le pont diviseur PD est alimenté par la source de tension ST avec la tension vref, et est couplé aux premier EC1 et second EC2 éléments de commutation via la diode DD. Il comprend, par exemple, deux résistances, éventuellement identiques. De plus, ce pont diviseur PD délivre une tension de sortie ts qui est soit égale à une tension de référence v1 en l'absence de fuite de l'un des premier EC1 et second EC2 éléments de commutation placé dans son état fermé (alors que l'autre est dans son état ouvert), soit différente de cette tension de référence v1 en présence d'une fuite de l'un des premier EC1 et second EC2 éléments de commutation placé dans son état fermé (alors que l'autre est dans son état ouvert). Comme le sait l'homme de l'art, la tension de référence v1 est fonction de la tension vref et des valeurs de ses deux résistances. Lorsque ces dernières sont identiques, la tension de référence v1 est égale à la moitié de la tension vref (soit v1 = vref/2).

On comprendra que lorsque l'un des premier EC1 et second EC2 éléments de commutation est placé dans son état fermé et ne fuit pas, tandis que l'autre est placé dans son état ouvert, le pont diviseur PD n'est pas influencé par les premier EC1 et second EC2 éléments de commutation, et donc délivre sur sa sortie une tension de sortie ts égale à la tension de référence v1 (soit ts = v1). En revanche, lorsque l'un des premier EC1 et second EC2 éléments de commutation est placé dans son état fermé et fuit, tandis que l'autre est placé dans son état ouvert, le pont diviseur PD est influencé par les premier EC1 et second EC2 éléments de commutation, et donc délivre sur sa sortie une tension de sortie qui diffère de la tension de référence v1 (soit ts ≠ v1).

A titre d'exemple, le pont diviseur PD peut présenter une impédance d'environ 100 kohms, si l'on veut détecter des fuites inférieures à 1 mA.

Le premier comparateur CP1 est agencé de manière à comparer la tension de sortie ts du pont diviseur PD à la tension de référence v1, et à délivrer un premier signal s1 qui est représentatif du résultat de cette comparaison.

On comprendra que si le premier élément de commutation EC1 est placé dans son état fermé et ne fuit pas, et que le second élément de commutation EC2 est placé dans son état ouvert, le premier comparateur CP1 délivre sur sa sortie un premier signal s1 qui est représentatif de l'absence de différence entre ts et v1 (et donc de l'absence de fuite de EC1). Si le premier élément de commutation EC1 est placé dans son état fermé et fuit, et que le second élément de commutation EC2 est placé dans son état ouvert, le premier comparateur CP1 délivre sur sa sortie un premier signal s1 qui est représentatif d'une différence entre ts et v1 (et donc de la présence d'une fuite de EC1). Si le second élément de commutation EC2 est placé dans son état fermé et ne fuit pas, et que le premier élément de commutation EC1 est placé dans son état ouvert, le premier comparateur CP1 délivre sur sa sortie un premier signal s1 qui est représentatif de l'absence de différence entre ts et v1 (et donc de l'absence de fuite de EC2). Si le second élément de commutation EC2 est placé dans son état fermé et fuit, et que le premier élément de commutation EC1 est placé dans son état ouvert, le premier comparateur CP1 délivre sur sa sortie un premier signal s1 qui est représentatif d'une différence entre ts et v1 (et donc de la présence d'une fuite de EC2).

Le contrôleur CT est agencé de manière à placer les premier EC1 et second EC2 éléments de commutation soit respectivement dans leurs états fermé et ouvert à des premiers instants choisis, soit respectivement dans leurs états ouvert et fermé à des deuxièmes instants choisis.

On comprendra que dans chaque premier instant on détermine si le premier élément de commutation EC1 fuit (ou non), tandis que dans chaque deuxième instant, on détermine si le second élément de commutation EC2 fuit (ou non).

Par exemple, le contrôleur CT peut être agencé de manière à utiliser comme premier instant de test chaque instant suivant une mise en fonctionnement du véhicule, et comme deuxième instant de test chaque instant suivant la fin d'un test effectué pendant un premier instant.

Une fois les tests des premier EC1 et second EC2 éléments de commutation réalisés, on dispose d'un état de fuite fiable, et en cas de fuite sur l'un des éléments de commutation ECj un calculateur (ne faisant, a priori, pas partie du dispositif d'inhibition DI) peut générer une alerte, ici à destination du conducteur du véhicule, pour lui signaler un besoin urgent d'effectuer un contrôle dans un service après-vente, et ordonner au contrôleur CT de n'utiliser que l'autre élément de commutation ECj' qui ne fuit pas.

On notera que le contrôleur CT peut, par exemple, être de type microcontrôleur.

On notera également, comme illustré non limitativement sur la figure 1, que le dispositif d'inhibition DI peut aussi comprendre un second comparateur CP2 agencé de manière à comparer la tension de sortie ts du pont diviseur PD à une tension seuil v2 que présente la diode DD en fonctionnement normal. Ce second comparateur CP2 est aussi agencé de manière à délivrer un second signal s2 qui est représentatif du résultat de sa comparaison lorsque les premier EC1 et second EC2 éléments de commutation sont placés tous les deux dans leur état fermé à des troisièmes instants choisis par le contrôleur CT.

On comprendra que si les premier EC1 et second EC2 éléments de commutation sont dans leur état fermé et que la diode DD fonctionne correctement, le second comparateur CP2 délivre sur sa sortie un second signal s2 qui est représentatif de l'absence de différence entre ts et v2. Si les premier EC1 et second EC2 éléments de commutation sont dans leur état fermé et que la diode DD ne fonctionne pas correctement, le second comparateur CP2 délivre sur sa sortie un second signal s2 qui est représentatif d'une différence entre ts et v2.

Par exemple, le contrôleur CT peut être agencé de manière à utiliser comme troisième instant de test chaque instant suivant la fin d'un test effectué pendant un deuxième instant.

On notera également, comme illustré non limitativement sur la figure 1, que l'un au moins des premier EC1 et second EC2 éléments de commutation peut comprendre un second transistor à effet de champ T2j installé en série avec son premier transistor à effet de champ T1j et tête-bêche (ou de façon opposée). Cette option est destinée à s'affranchir des pannes simples. L'ajout d'un second transistor T2j permet en effet d'assurer qu'en cas de défaillance du premier transistor T1j associé le second transistor T2j sera là pour isoler la première défaillance. Ainsi la panne simple n'est pas contraire à la sécurité. L'utilisation de deux transistors T1j et T2j tête-bêche permet de contrôler le courant dans les deux sens de circulation. Les premier T1j et second T2j transistors à effet de champ sont par exemple commandés par le contrôleur CT au moyen d'un même signal de commande. Dans ce cas, une première commande place les premier T1j et second T2j transistors à effet de champ respectivement dans leurs états ouvert et fermé, et une seconde commande place les premier T1j et second T2j transistors à effet de champ respectivement dans leurs états fermé et ouvert. Ce type de test de fuite est préférentiellement effectué lorsque le véhicule est à l'arrêt (de façon périodique, en quelques millisecondes). Bien entendu, en fonctionnement nominal les premier EC1 et second EC2 éléments de commutation sont fermés.

Dans l'exemple illustré non limitativement sur la figure 1, seul le premier élément de commutation EC1 comprend des premier T11 et second T21 transistors à effet de champ, le second élément de commutation EC2 ne comprenant qu'un premier transistor à effet de champ T12. Mais les premier EC1 et second EC2 éléments de commutation pourraient chacun comprendre des premier T11 et second T22 transistors à effet de champ, ou bien seul le second élément de commutation EC2 pourrait comprendre des premier T12 et second T22 transistors à effet de champ, le premier élément de commutation EC1 ne comprenant qu'un premier transistor à effet de champ T11. La mise en oeuvre choisie dépend de l'événement redouté dont on souhaite se protéger (si l'on veut se protéger contre les fuites dans les deux sens il faut prévoir des premier EC1 et second EC2 éléments de commutation comportant chacun des premier T11 et second T22 transistors tête-bêche).

On notera également, comme illustré non limitativement sur la figure 1, que le dispositif d'inhibition DI peut aussi comprendre des premier I1 et second I2 interrupteurs. Le premier interrupteur I1 a une entrée qui est destinée à être connectée à la sortie de l'équipement EE en amont du premier élément de commutation EC1, une première sortie connectée à l'entrée de la diode DD et une seconde sortie. Le second interrupteur I2 a une entrée qui est destinée à être connectée à la sortie de l'équipement EE en aval du second élément de commutation EC2, une première sortie connectée à la seconde sortie du premier interrupteur I1 et une seconde sortie connectée à l'entrée de la diode DD. Dans ce cas, le contrôleur CT est agencé de manière à placer les premier I1 et second I2 interrupteurs soit dans un premier état dans lequel ils couplent chacun leur entrée à leur première sortie, soit dans un second état dans lequel ils couplent chacun leur entrée à leur seconde sortie. Ces placements se font au moyen de signaux de commande fournis par le contrôleur CT.

On comprendra que lorsque les premier I1 et second I2 interrupteurs sont dans leur premier état, on peut tester les fuites des premier EC1 et second EC2 éléments de commutation selon un premier sens de circulation du courant, tandis que lorsque les premier I1 et second I2 interrupteurs sont dans leur second état, on peut tester les fuites des premier EC1 et second EC2 éléments de commutation selon un second sens de circulation du courant (opposé au premier).

On notera également, comme illustré non limitativement sur la figure 1, que chaque comparateur CPj du dispositif d'inhibition DI peut être éventuellement associé à un composant optoélectronique COj chargé de transformer le signal sj qu'il délivre sur sa sortie en un autre signal Sj' au niveau de la tension de la batterie EE. Cette option est mise en oeuvre lorsque les tests de fuite sont référencés par rapport à la batterie EE, et donc lorsqu'il faut ramener les signaux par rapport à la masse.

On notera également, comme illustré non limitativement sur la figure 1, que le dispositif d'inhibition DI peut éventuellement comprendre un autre composant optoélectronique CO3 chargé de transformer le signal de commande issu du contrôleur CT, au niveau de la tension de la batterie EE, et destiné aux interrupteurs Ij en un autre signal de commande adapté à ces interrupteurs Ij.

La diode DD, le pont diviseur PD, la source de tension ST, le premier comparateur CP1, l'éventuel second comparateur CP2, les éventuels interrupteurs Ij, et les éventuels composants optoélectroniques COj et CO3 forment ensemble un dispositif de test DT surveillant les éléments de commutation ECj.

Grâce à l'invention, on utilise désormais des éléments de commutation ECj pouvant présenter des fuites à la place des relais, ce qui permet d'obtenir un important pouvoir de coupure de courant, un important nombre de commutations (et donc d'inhibitions), une fiabilité importante, tout en nécessitant une faible énergie de commande. La possibilité de fuite des éléments de commutation ECj est surveillée par le dispositif de test DT, ce qui permet d'éviter les incidents avant qu'ils ne surviennent et les opérations de maintenance anticipatives.

## Revendications

1. Dispositif d'inhibition (DI) pour inhiber la sortie d'un équipement (EE) délivrant un courant électrique, comprenant i) des premier (EC1) et second (EC2) éléments de commutation destinés à être installés en série, tête-bêche, sur ladite sortie et pouvant chacun être placés dans un état ouvert passant ou un état fermé non passant en l'absence de fuite, ii) un pont diviseur (PD) alimenté par une source de tension (ST), couplé auxdits premier (EC1) et second (EC2) éléments de commutation via une diode (DD), et délivrant une tension de sortie soit égale à une tension de référence en l'absence de fuite de l'un desdits premier (EC1) et second (EC2) éléments de commutation placé dans son état fermé, l'autre étant dans son état ouvert, soit différente de cette tension de référence en présence d'une fuite de l'un desdits premier (EC1) et second (EC2) éléments de commutation placé dans son état fermé, l'autre étant dans son état ouvert, iii) un premier comparateur (CP1) comparant ladite tension de sortie du pont diviseur (PD) à ladite tension de référence et délivrant un premier signal représentatif d'un résultat de ladite comparaison, et iv) un contrôleur (CT) plaçant lesdits premier (EC1) et second (EC2) éléments de commutation soit respectivement dans leurs états fermé et ouvert à des premiers instants choisis, soit respectivement dans leurs états ouvert et fermé à des deuxièmes instants choisis, comprenant i) un premier interrupteur (11) ayant une entrée destinée à être connectée à ladite sortie de l'équipement (EE) en amont dudit premier élément de commutation (EC1), une première sortie connectée à une entrée de ladite diode (DD), et une seconde sortie, et ii) un second interrupteur (I2) ayant une entrée destinée à être connectée à ladite sortie de l'équipement (EE) en aval dudit second élément de commutation (EC2), une première sortie connectée à ladite seconde sortie du premier interrupteur (11), et une seconde sortie connectée à ladite entrée de la diode (DD), et en ce que ledit contrôleur (CT) place lesdits premier (11) et second (I2) interrupteurs soit dans un premier état dans lequel ils couplent chacun leur entrée à leur première sortie, soit dans un second état dans lequel ils couplent chacun leur entrée à leur seconde sortie.

2. Dispositif selon la revendication 1, comprenant un second comparateur (CP2) comparant ladite tension de sortie du pont diviseur (PD) à une tension seuil que présente ladite diode (DD) en fonctionnement normal, et délivrant un second signal représentatif d'un résultat de ladite comparaison lorsque lesdits premier (EC1) et second (EC2) éléments de commutation sont placés dans leur état fermé à des troisièmes instants choisis par ledit contrôleur (CT).

3. Dispositif selon la revendication 1 ou 2, dans lequel chacun desdits premier (EC1) et second (EC2) éléments de commutation comprend au moins un premier transistor à effet de champ (T1j).

4. Dispositif selon la revendication 3, dans lequel l'un au moins desdits premier (EC1) et second (EC2) éléments de commutation comprend un second transistor à effet de champ (T2j) installé en série avec son premier transistor à effet de champ (T1j) et tête-bêche.

5. Equipement (EE) comprenant une sortie délivrant un courant électrique, et comprenant en outre un dispositif d'inhibition (DI) selon l'une des revendications précédentes, installé sur ladite sortie.

6. Equipement selon la revendication 5, constituant une batterie.

7. Véhicule, comprenant au moins un équipement (EE) selon la revendication 5 ou 6.

8. Véhicule selon la revendication 7, étant de type automobile.

## Patentansprüche

1. Sperrvorrichtung (DI) zum Sperren des Ausgangs von Geräten (EE), die elektrischen Strom liefern, bestehend aus i) ersten (EC1) und zweiten (EC2) Schaltelementen, die dazu bestimmt sind, in Reihe, Kopf-Spaten, an dem Ausgang installiert zu werden und die jeweils in einen offenen Durchgangszustand oder einen geschlossenen, nicht leitenden Zustand versetzt werden können, wenn kein Leck vorhanden ist, ii) eine Teilerbrücke (PD), die von einer Spannungsquelle (ST) gespeist wird und mit dem ersten (EC1) und dem zweiten ( EC2) Schaltelemente über eine Diode (DD) und liefert eine Ausgangsspannung, die einer Referenzspannung entspricht, wenn eines der ersten (EC1) und zweiten (EC2) Schaltelemente in den geschlossenen Zustand versetzt wird und das andere nicht leckt in seinem offenen Zustand oder von dieser Referenzspannung abweichend bei Vorhandensein eines Lecks von einem der genannten ersten (EC1) und zweiten (EC2) Schaltelemente, die sich in ihrem geschlossenen Zustand befinden, während sich das andere in seinem offenen Zustand befindet, iii) ein erstes Komparator (CP1), der die Ausgangsspannung der Teilerbrücke (PD) mit der Referenzspannung vergleicht und ein erstes Signal liefert, das ein Ergebnis des Vergleichs darstellt, und iv) eine Steuerung (CT), die das erste (EC1) und zweite (EC2) platziert) Schaltelemente, die entweder zu ersten gewählten Zeitpunkten jeweils in ihrem geschlossenen und offenen Zustand oder zu zweiten gewählten Zeitpunkten in ihrem offenen und geschlossenen Zustand sind, umfassend i) einen ersten Schalter (I1) mit einem Eingang, der dazu bestimmt ist, mit dem Ausgang des Schalters verbunden zu werden eine Ausrüstung (EE) vor dem ersten Schaltelement (EC1), einen ersten Ausgang, der mit einem Eingang der Diode (DD) verbunden ist, und einen zweiten Ausgang, und ii) einen zweiten Schalter (I2), der einen Eingang aufweist, der mit diesem verbunden werden soll wobei der Ausgang des Geräts (EE) stromabwärts des zweiten Schaltelements (EC2) liegt, ein erster Ausgang mit dem zweiten Ausgang des ersten Schalters (I1) verbunden ist und ein zweiter Ausgang mit dem Eingang der Diode (DD) verbunden ist, und , dass der Controller (CT) den ersten (I1) und zweiten (I2) Schalter entweder in einen ersten Zustand versetzt, in dem sie jeweils ihren Eingang mit ihrem ersten Ausgang koppeln, oder in einen zweiten Zustand, in dem sie jeweils ihren Eingang mit ihrem ersten Ausgang koppeln zweiter Ausgang.

2. Vorrichtung nach Anspruch 1, umfassend einen zweiten Komparator (CP2), der die Ausgangsspannung der Teilerbrücke (PD) mit einer von der Diode (DD) im Normalbetrieb bereitgestellten Schwellenspannung vergleicht und ein zweites Signal liefert, das ein Ergebnis darstellt des Vergleichs, wenn die ersten (EC1) und zweiten (EC2) Schaltelemente zu dritten, von der Steuerung (CT) gewählten Zeitpunkten in ihren geschlossenen Zustand versetzt werden.

3. Vorrichtung nach Anspruch 1 oder 2, wobei jedes der ersten (EC1) und zweiten (EC2) Schaltelemente mindestens einen ersten Feldeffekttransistor (T1j) umfasst.

4. Vorrichtung nach Anspruch 3, wobei mindestens eines der ersten (EC1) und zweiten (EC2) Schaltelemente einen zweiten Feldeffekttransistor (T2j) umfasst, der in Reihe mit seinem ersten Feldeffekttransistor (T1j) und Kopf-an-Schwanz installiert ist.

5. Gerät (EE), umfassend einen Ausgang, der einen elektrischen Strom liefert, und außerdem umfassend eine Sperrvorrichtung (DI) nach einem der vorhergehenden Ansprüche, die an diesem Ausgang installiert ist.

6. Gerät nach Anspruch 5, bestehend aus einer Batterie.

7. Fahrzeug, umfassend mindestens ein Ausrüstungsteil (EE) nach Anspruch 5 oder 6.

8. Fahrzeug nach Anspruch 7, vom Typ Automobil.

## Claims

1. Inhibition device (DI) for inhibiting the output of equipment (EE) delivering an electric current, comprising i) first (EC1) and second (EC2) switching elements intended to be installed in series, head- spade, on said output and which can each be placed in an open passing state or a closed non-conducting state in the absence of leak, ii) a divider bridge (PD) supplied by a voltage source (ST), coupled to said first ( EC1) and second (EC2) switching elements via a diode (DD), and delivering an output voltage equal to a reference voltage in the absence of leakage of one of said first (EC1) and second (EC2) switching elements placed in its closed state, the other being in its open state, or different from this reference voltage in the presence of a leak from one of said first (EC1) and second (EC2) switching elements placed in its closed state, the other being in its open state, iii) a first comparator (CP1) comparing said output voltage of the divider bridge (PD) to said reference voltage and delivering a first signal representative of a result of said comparison , and iv) a controller (CT) placing said first (EC1) and second (EC2) switching elements either respectively in their closed and open states at first chosen instants, or respectively in their open and closed states at second chosen instants, comprising i) a first switch (I1) having an input intended to be connected to said output of the equipment (EE) upstream of said first switching element (EC1), a first output connected to an input of said diode (DD ), and a second output, and ii) a second switch (I2) having an input intended to be connected to said output of the equipment (EE) downstream of said second switching element (EC2), a first output connected to said second output of the first switch (11), and a second output connected to said input of the diode (DD), and in that said controller (CT) places said first (I1) and second (I2) switches either in a first state in which they each couple their input to their first output, or in a second state in which they each couple their input to their second output.

2. Device according to claim 1, comprising a second comparator (CP2) comparing said output voltage of the divider bridge (PD) to a threshold voltage presented by said diode (DD) in normal operation, and delivering a second signal representative of a result of said comparison when said first (EC1) and second (EC2) switching elements are placed in their closed state at third instants chosen by said controller (CT).

3. Device according to claim 1 or 2, wherein each of said first (EC1) and second (EC2) switching elements comprises at least one first field effect transistor (T1j).

4. Device according to claim 3, wherein at least one of said first (EC1) and second (EC2) switching elements comprises a second field effect transistor (T2j) installed in series with its first field effect transistor (T1j) and head to tail.

5. Equipment (EE) comprising an output delivering an electric current, and further comprising an inhibition device (DI) according to one of the preceding claims, installed on said output.

6. Equipment according to claim 5, constituting a battery.

7. Vehicle, comprising at least one piece of equipment (EE) according to claim 5 or 6.

8. Vehicle according to claim 7, being of automobile type.
